# FASCICULE DE BREVET EUROPEEN

(11) **EP 0 718 849 B1**
(45) Date de publication et mention de la délivrance du brevet: **22.04.1998**
(21) Numéro de dépôt: 95402820.5
(22) Date de dépôt: 14.12.1995
(51) Int. Cl.: G11C 16/06

(54) **Procédé d'écriture de données dans une mémoire et mémoire électriquement programmable correspondante**
Verfahren zum Einschreiben von Daten in einen Speicher und entsprechender elektrisch-programmierbarer Speicher
Method of writing data in a memory and corresponding electrically programmable memory

(30) Priorité: 20.12.1994 FR 9415348
(43) Date de publication de la demande: 26.06.1996
(73) Titulaire: SGS-THOMSON MICROELECTRONICS S.A., 94250 Gentilly (FR)
(72) Inventeur: Aulas, Maxence, F-75116 Paris (FR); Brigati, Alessandro, F-75116 Paris (FR); Demange, Nicolas, F-75116 Paris (FR); Guedj, Marc, F-75116 Paris (FR)
(74) Mandataire: Schmit, Christian Norbert Marie

(56) Documents cités:
- US-A- 4 218 764
- US-A- 4 763 305
- US-A- 5 239 505
- US-A- 5 365 486

## Description

La présente invention concerne les mémoires non volatiles électriquement programmables et effaçables.

Les mémoires de type EEPROM sont tout particulièrement concernées. Toutefois, l'invention est applicable à des mémoires de technologie différente mais dans lesquelles des problèmes similaires se posent.

Les mémoires EEPROM utilisent, pour l'enregistrement de données, le stockage de charges électriques sur une grille flottante de transistor. Le transistor à grille flottante peut être rendu conducteur par application d'une tension de lecture sur une grille de commande. Selon la quantité de charges stockées sur la grille flottante, le seuil de mise en conduction du transistor varie, et c'est cette variation du seuil qui permet de déterminer si le transistor est effacé ou programmé.

Par conséquent, la lecture des données s'effectue en portant la grille de commande à un potentiel de référence déterminé. Ce potentiel de référence est choisi sensiblement au milieu de l'intervalle entre la tension de seuil de mise en conduction d'un transistor programmé et la tension de seuil de mise en conduction d'un transistor effacé. Ainsi, si le transistor est programmé il sera rendu conducteur par l'application du potentiel de référence sur sa grille flottante; s'il est effacé il ne sera pas rendu conducteur.

Les quantités de charges électriques stockées sur la grille flottante sont cependant difficiles à contrôler, et d'autre part, la pérennité du stockage de ces charges n'est pas bien maîtrisée. Les tensions de seuil de conduction se modifient au cours du temps. Elles se modifient notamment en fonction du nombre de cycles d'écriture ou d'effacement exécutés dans la mémoire.

Il peut arriver que le vieillissement de l'information contenue dans une cellule soit tel que le circuit de lecture (utilisant le potentiel de référence) ne permette plus de déterminer avec une certitude suffisante si une cellule de mémoire est effacée ou programmée. Ceci est décrit dans les documents US-A-5 365 486 et US-A-5 239 505. On reviendra plus loin sur les causes possibles de ce vieillissement.

L'invention propose une solution pour éviter les risques de dégradation excessive de l'information stockée dans une cellule. Cette solution consiste dans l'utilisation d'une séquence d'opérations originale lors d'une étape d'écriture d'un mot dans la mémoire. Cette séquence comprend une vérification systématique des informations contenues dans des autres mots d'une ligne de mémoire au moment de l'écriture d'un mot contenu dans cette ligne, et une réécriture systématique des mots de cette ligne où une dégradation d'information apparaît. On considère qu'il y a une dégradation d'information si au moins une cellule de mémoire du mot fournit une information avec un risque d'erreur anormalement élevé. On pourrait réécrire toute la ligne mais on préfère ne réécrire que le ou les mots défectueux. En outre du fait d'une organisation de mémoire en octets, on préfère agir sur un octet plutôt que sur un mot entier, si un mot dans une architecture retenue comporte plusieurs octets.

Plus précisément, on propose selon l'invention un procédé d'écriture de données dans une mémoire électriquement programmable, caractérisé en ce que, pour l'écriture d'un mot dans un groupe de n cellules de mémoire, sélectionné dans une ligne de la mémoire (n supérieur ou égal à 1), on effectue la séquence d'opérations suivante :
- on lit l'état de cellules de mémoire de la ligne, en utilisant des valeurs de référence de lecture différentes,
- on vérifie la concordance des lectures effectuées sur une même cellule avec des valeurs de référence différentes, et, si on trouve une absence de concordance pour au moins une cellule d'un mot lu, on réécrit la cellule du mot lu de cette ligne;
- on écrit le mot désiré dans le groupe de cellules sélectionné.

De préférence le nombre des valeurs de référence est trois. Mais on peut ne faire que deux lectures, notamment si on découvre qu'un sens de dégradation est prépondérant par rapport à un autre. Ceci est en particulier le cas lorsqu'on lit avec une valeur centrale d'abord et où, en fonction de l'état lu, on sait que la dégradation ne peut provenir que d'une seule façon.

En d'autres mots, une écriture (soit plus généralement une modification de cellules, comportant un effacement ou plutôt un effacement suivi d'une programmation des cellules d'un mot) est précédée d'une étape de vérification de l'état d'autres cellules de la ligne. S'il n'y a pas de problème (la concordance des résultats des trois lectures indique qu'il n'y a pas de dégradation excessive de l'état des cellules de la ligne), l'étape d'écriture du mot est effectuée. S'il y a un problème de dégradation d'information, la triple lecture par rapport à des potentiels de référence différents permet de déceler le problème, et la nature et le lieu de la dégradation (risque de perte d'information sur une cellule effacée ou au contraire sur une cellule programmée); on réécrit alors la cellule défectueuse, de préférence tout un octet de cellules où cette cellule défectueuse se trouve. Et le mot à écrire est écrit de préférence au cours de cette réécriture.

Cette solution de vérification systématique avant toute écriture permet de détecter les risques de perte d'information, et notamment ceux qui sont dus à la dégradation d'une cellule par suite des cycles d'écriture dans les autres cellules de la même ligne.

Dans le cas d'une mémoire à transistor à grille flottante, les valeurs de référence de lecture sont des potentiels appliqués à la grille de commande, et la lecture est en quelque sorte une comparaison entre ces potentiels et une tension de seuil de conduction du transistor effacé ou programmé; mais on comprendra que ces valeurs de référence peuvent être d'autres tensions ou courants de référence, ceci en fonction de la technologie et la circuiterie utilisées pour les cellules de mémoire. Notamment il peut s'agir des tensions appliquées sur les drains et sources des transistors à grille flottante des cellules.

On utilisera pour la lecture une valeur de référence centrale, une valeur de référence auxiliaire basse, inférieure à la valeur centrale, et une valeur de référence auxiliaire haute, supérieure à la valeur centrale. Le potentiel de référence central correspond de préférence sensiblement au milieu de l'intervalle entre les seuils de conduction d'une cellule qui vient d'être effacée et d'une cellule qui vient d'être programmée.

Les valeurs de référence auxiliaires sont choisies de manière à détecter un degré déterminé de dégradation de l'information, comme on l'expliquera plus loin.

Outre le procédé ainsi défini, l'invention a également pour objet une mémoire électriquement programmable comportant des moyens pour effectuer successivement trois lectures des cellules d'une ligne (une partie ou la ligne entière), avant chaque écriture d'un mot de cette ligne, les trois lectures étant effectuées en utilisant trois potentiels de référence différents.

La mémoire, organisée en lignes de mots d'au moins un bit peut comporter plus précisément :
- un circuit de lecture apte à lire les mots de la mémoire avec trois valeurs de référence différentes;
- un registre pour stocker des mots lus dans une ligne de mémoire;
- un séquenceur d'écriture apte à effectuer les opérations suivantes lorsqu'il reçoit un ordre d'écriture d'un mot à un emplacement déterminé d'une ligne de la mémoire : lecture de l'état des cellules de mémoire de la ligne, en utilisant les trois valeurs de référence de lecture différentes, réécriture systématique, si nécessaire, des cellules défectueuses d'une ligne de mémoire stockés dans le registre, et écriture d'un mot désiré à un emplacement de mot de cette ligne, et
- des moyens de comparaison des résultats de la lecture d'une même cellule avec les trois valeurs de référence, ces moyens étant connectés au séquenceur pour fournir un ordre de réécriture systématique de la cellule si une non-concordance des trois résultats est détectée.

On comprendra qu'il n'est pas nécessaire de lire tous les mots de la ligne avec chacune des trois valeurs de référence, puisque dès qu'une non-concordance est détectée, les mots suivants peuvent être lus avec un seul potentiel de référence (potentiel standard de lecture).

D'autres caractéristiques et avantages de l'invention apparaîtront à la lecture de la description détaillée qui suit et qui est faite en référence aux dessins annexés dans lesquels:
- la figure 1 représente un agencement de cellules de mémoire EEPROM;
- la figure 2 représente des courbes de variation typiques des tensions de seuil de conduction d'une cellule effacée et d'une cellule programmée, en fonction des nombres de cycles de programmation des autres cellules de la ligne; et
- la figure 3 représente une structure générale de mémoire selon l'invention.

On va revenir maintenant sur une des causes des pertes d'information dans une cellule de mémoire. Le risque de perte vient du principe même des choix des potentiels d'écriture et d'effacement des cellules de mémoire dans une organisation matricielle de mémoire : du fait que les cellules sont agencées en lignes et colonnes, toutes les grilles de commande des transistors à grille flottante d'une même ligne sont connectées entre elles; toutes les sources des transistors à grille flottante sont reliées entre elles, du moins à priori. Il faut cependant que les potentiels appliqués à un transistor qu'on doit programmer ou effacer soient sélectifs et n'entraînent pas la programmation des autres transistors de la même ligne ou de la même colonne.

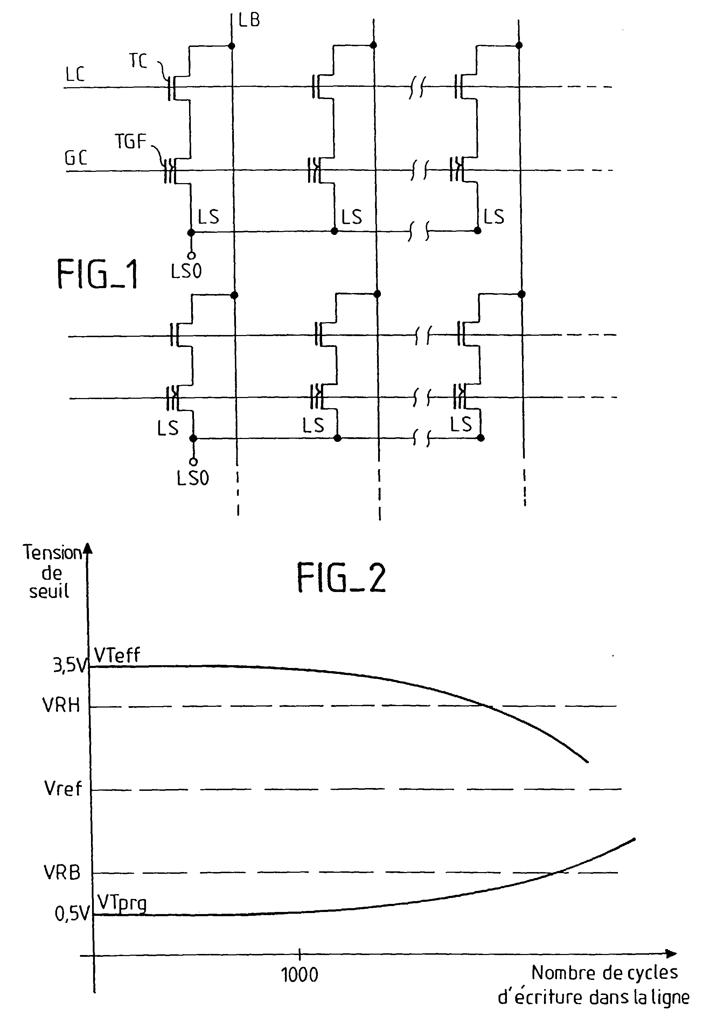

Un agencement classique de réseau de cellules de mémoire EEPROM est représenté à la figure 1. Chaque cellule comporte un transistor à grille flottante TGF et un transistor de commande TC. Le transistor à grille flottante a sa source reliée à une ligne de source LS, qui peut être commune à tout le réseau. Il a son drain relié à la source du transistor de commande et sa grille de commande reliée à une ligne GC commune à tous les transistors d'une même ligne. Le drain du transistor de commande TC est relié à une ligne de bit LB commune à tous les transistors d'une même colonne. Enfin, la grille de commande du transistor de commande TC est reliée à une ligne de sélection LC commune à tous les transistors d'une même ligne. Dans un exemple, dans l'invention, les lignes de source des cellules d'un même octet sont connectées à une ligne de source commune d'octet LSO. La figure 1 montre deux octets. Les lignes de source d'octets LSO sont commandables individuellement par un décodeur.

Pour l'effacement d'une cellule située au carrefour d'une ligne et d'une colonne déterminées, on applique une tension d'effacement d'environ 15 volts sur la ligne GC dans laquelle se situe la cellule à effacer; simultanément, on applique 0 volts sur la ligne de source LS correspondant à la cellule à effacer, et 5 volts environ sur les lignes de source des autres cellules. En pratique, en soumettant les lignes de source commune d'octet LSO à ces tensions on efface ou on sauvegarde toutes les cellules de l'octet en même temps. L'effacement de la cellule résulte de la différence de potentiel importante (15 volts) entre la source et la grille du transistor à grille flottante sélectionné, alors que les transistors de la même ligne appartenant à des colonnes ou des octets différents reçoivent entre leur source et leur grille une tension inférieure (environ 10 volts), qui ne suffit pas à l'effacement.

De même, la programmation de la cellule située au carrefour d'une ligne et d'une colonne comporte l'application d'une tension d'environ -8 volts sur la ligne GC (donc sur la grille des transistors à grille flottante) et +5 volts ou 0 volts sur le drain selon que le transistor est sélectionné pour une écriture ou non. La différence de potentiel qui en résulte entre grille et drain est soit de 13 volts pour la cellule sélectionnée (ce qui suffit à l'écrire), soit de 8 volts seulement pour les autres cellules de la ligne (ce qui ne suffit pas). Un mot de plusieurs bits est écrit dans un groupe de cellules (préalablement effacées) en mettant 0 volt ou 5 volts sur les lignes de bit des différentes cellules du groupe, selon la valeur des bits du mot.

Les décodeurs de l'état de la technique peuvent déjà permettre l'écriture simultanée des différentes cellules d'un groupe en imposant les tensions adéquates sur l'ensemble des lignes de bit du mot.

Cependant, bien que des tensions de protection appropriées soient appliquées aux transistors qu'on ne veut pas effacer ou programmer, pendant l'effacement ou la programmation d'un autre transistor, on constate que ces tensions de protection ont une influence sur l'état de programmation des transistors qui les reçoivent.

En d'autres mots, un effacement ou une programmation d'un transistor modifie légèrement l'état de charge de la grille flottante des autres transistors de la même ligne.

C'est un des raisons pour lesquelles on constate que la tension de seuil de mise en conduction d'un transistor effacé ou programmé évolue au fur et à mesure des programmations ou effacements des autres cellules, principalement celles de la même ligne.

Les courbes de la figure 2 représentent une variation typique des tensions de seuil de mise en conduction d'un transistor à grille flottante d'une mémoire EEPROM.

L'évolution de la tension de seuil VTeff (transistor effacé) et de la tension de seuil VTprg (transistor programmé) est représentée en fonction du nombre de cycles d'écriture effectués dans la mémoire. La tension de référence Vref est celle qu'on applique à la grille de commande du transistor à grille flottante pour une opération de lecture standard. On voit que les tensions de seuil ont tendance à se rapprocher l'une de l'autre au cours du temps. Il devient donc difficile d'être sûr qu'elles ne se rapprochent pas trop de la tension de référence. Il y a dégradation de l'information contenue dans la cellule.

C'est pourquoi on prévoit selon l'invention une vérification systématique de l'information, par une triple lecture par rapport à des potentiels de référence différents, et une réécriture des informations si les résultats de la triple lecture montrent une dégradation des charges contenues dans la grille flottante des cellules. Cette vérification est effectuée, pour une ligne déterminée, au moment de l'écriture d'un mot dans cette ligne de mémoire. La raison en est que ce sont les écritures d'un mot d'une ligne qui tendent à dégrader l'information contenue dans les autres mots. Par conséquent on a avantage à vérifier une ligne à chaque fois qu'on va écrire dans cette ligne. Il n'y a pas besoin de vérifier systématiquement les lignes dans lesquelles on écrit rarement et surtout celles où on n'est pas en train d'écrire.

La vérification est faite dans toute la ligne. La réécriture est également faite éventuellement pour toute la ligne.

Les trois lectures se font par rapport aux potentiels suivants :
- potentiel de référence central Vref, de préférence au milieu de l'intervalle entre la valeur de tension de seuil VTprg d'un transistor à grille flottante qui vient d'être programmé et la valeur de la tension de seuil VTeff d'un transistor à grille flottante qui vient d'être effacé;
- potentiel de référence auxiliaire haut VRH, supérieur à Vref mais inférieur à VTeff; et
- potentiel de référence auxiliaire bas VRB, inférieur à Vref mais supérieur à VTprg.

Comme on peut le voir sur la figure 2, une lecture d'une cellule programmée non dégradée par de nombreux cycles d'écriture d'autres cellules de la mémoire, donnera le même résultat au moment de la lecture quel que soit le potentiel de lecture utilisé : Vref, VRH ou VRB. Le transistor sera toujours rendu conducteur puisque toutes ces tensions de lecture sont supérieures à la tension de seuil VTprg. De même pour une cellule effacée : les trois lectures laisseront le transistor bloqué, indiquant de toutes façons l'état effacé.

Mais après de nombreux cycles d'écriture d'autres cellules dans la même ligne de mémoire, la cellule considérée verra sa tension de seuil baisser si elle est effacée, ou augmenter si elle est programmée.

Premier cas : les trois lectures sont concordantes et montrent que la tension de seuil est supérieure à VRH; il faut en conclure que la cellule est effacée et que l'information n'est pas encore dégradée.

Deuxième cas : les trois lectures ne sont pas concordantes et montrent que la tension de seuil est comprise entre Vref et VRH; il faut en conclure que la cellule est effacée mais que l'information a commencé à se dégrader.

Troisième cas : les trois lectures sont concordantes et montrent que la tension est inférieure à VRB. On en conclut que la cellule est programmée et que cette information n'est pas dégradée.

Quatrième cas : les trois lectures ne sont pas concordantes et montrent que la tension de seuil est comprise entre VRB et Vref. On en conclut que la cellule est programmée, avec dégradation de l'information.

En pratique, une opération d'écriture d'un mot de n bits (n supérieur ou égal à 1) dans un groupe de n cellules d'une ligne de la mémoire comporte les étapes suivantes :
- lecture systématique successive de tous les mots de la ligne, en utilisant, au moins au début, les trois potentiels de référence Vref, VRH, VRB; la lecture par rapport au potentiel Vref donne l'indication de l'information stockée; la lecture par rapport aux autres potentiels de référence VRH et VRB donne, par comparaison avec la première lecture, une indication de dégradation (deuxième et quatrième cas ci-dessus) ou non-dégradation (premier et troisième cas ci-dessus) de l'information;
- mémorisation de tous les mots défectueux dans un registre;
- si au moins une cellule d'un mot comporte une information dégradée, réécriture systématique de toutes les cellules de ce mot, en utilisant le contenu du registre;
- et écriture du mot désiré de n bits. L'écriture du mot désiré est effectuée de préférence en même temps que la réécriture du ou des mots à réécrire. En effet sur les mémoires de type EEPROM ou l'écriture se fait par effet tunnel par application de hautes tensions, il n'y a aucune difficulté à soumettre autant de lignes que souhaitées à ces hautes tensions puisqu'il n'y a pas consommation de courant.

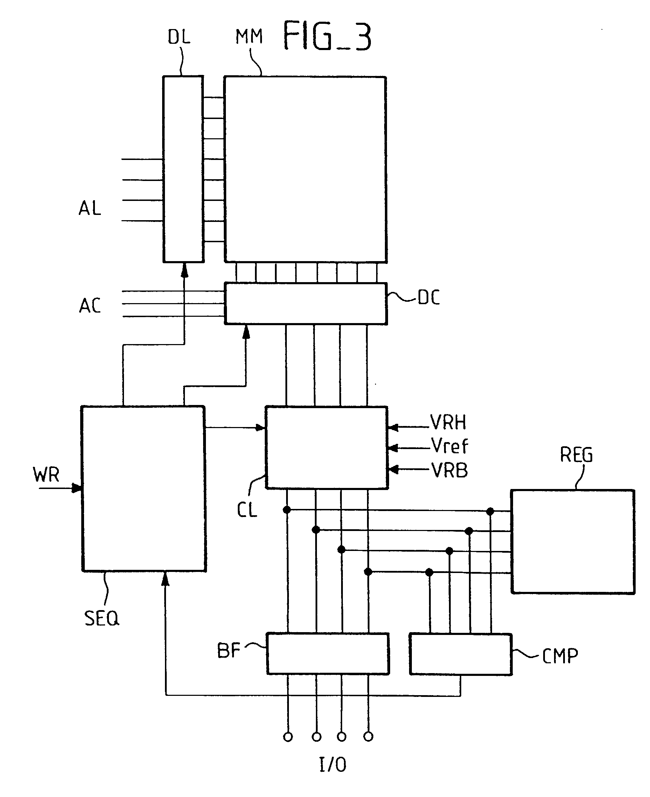

La mémoire selon l'invention est représentée sur la figure 3. Elle comporte classiquement un réseau MM de cellules en lignes et colonnes, par exemple avec un décodeur de ligne DL et un décodeur de colonne DC, pour recevoir respectivement une adresse de ligne AL et une adresse de mot AC dans la ligne. Le décodeur de colonne commande les lignes de bits et les connexions LSO.

Un circuit de lecture CL permet la lecture des mots avec trois potentiels de référence différents Vref, VRH, VRB. Dans la configuration de mémoire de la figure 1, le potentiel de référence est appliqué à la ligne GC.

Un comparateur en sortie du circuit de lecture permet de stocker trois lectures successives et de fournir une information sur la concordance ou la non-concordance des trois lectures.

Un registre REG est connecté en sortie du circuit de lecture pour stocker sinon l'ensemble des mots d'une ligne, lus avec le potentiel de référence central Vref au moins ceux qui sont défectueux. Ce registre peut restituer ces mots vers la mémoire pour une réécriture systématique si elle s'avère nécessaire. Et enfin, un automate d'écriture ou séquenceur SEQ exécute le sequencement d'opérations nécessaires au moment où un ordre d'écriture WR est donné, afin que la lecture préalable, la vérification et la réécriture éventuelle s'effectuent automatiquement sur la ligne correspondant à l'adresse du mot à écrire.

Sur la figure 3, on a encore représenté un circuit tampon BF interposé entre la sortie du circuit de lecture et les entrées-sorties I/O de la mémoire, pour stocker un mot à écrire dans la mémoire pendant le déroulement des opérations de vérification systématiques selon l'invention.

On notera que sur la figure 3 on n'a pas représenté les circuits d'écriture dans la mémoire. On considérera qu'ils peuvent être classiques et partiellement incorporés au circuit de lecture CL qui doit être considéré comme transparent lors de l'écriture d'un mot en provenance des entrées-sorties I/O ou du registre REG.

Dans le sequencement de l'opération d'écriture avec lecture systématique de toute la ligne, on peut prévoir que la comparaison entre la lecture normale à Vref et les deux autres lectures à VRH et VRB est faite immédiatement au moment de la lecture de chaque mot, et ceci pour tous les mots de la ligne mémoire. L'existence d'au moins une dégradation est détectée et cette information est envoyée au séquenceur. De préférence si deux lectures pour une même cellule ne sont pas concordantes, on gagne du temps en évitant de faire la troisième lecture pour cette cellule ou plutôt même pour l'octet. Si une cellule dans un mot a une information dégradée, de préférence on lit trois fois les autres mots ou octets sur la même ligne de mot pour ne réécrire en fin de compte que ceux qui sont défectueux. S'agissant d'un mot à écrire, et dont l'écriture justifie la procédure de trois lectures évoquées, on évite de lire au préalable le contenu de ce mot puisque de toute façon ce contenu sera changé. On gagne ainsi en temps de lecture.

En variante on peut prévoir aussi que dès qu'une information dégradée a été détectée, l'information de dégradation est enregistrée et la lecture des mots suivants de toute la ligne s'effectue uniquement avec Vref, dans le but de stocker tous les mots de la ligne dans le registre. En effet, une fois qu'une information dégradée a été trouvée, il n'est pas nécessaire d'en trouver d'autres, si un ordre de réécriture systématique de toute la ligne doit être donné au séquenceur. Mais l'exécution de cet ordre nécessite de poursuivre la lecture et le stockage de tous les mots dans le registre REG.

En ce qui concerne le choix des valeurs VRH et VRB, on peut se référer aux courbes typiques d'évolution des tensions de seuil de cellules effacées ou programmées. La valeur VRH doit être suffisamment proche de VTeff pour qu'une dégradation soit assez rapidement détectée. De même pour VRB et VTprg. Mais elle doit quand même être suffisamment éloignée pour qu'il n'y ait pas de risque (en fonction de la dispersion des caractéristiques des cellules) que VRH soit supérieur à la tension de seuil VTeff d'une cellule fraîchement effacée. De même pour VRB et VTprg.

Avec des lignes de 512 cellules organisées par 8, il y a 64 octets. La triple lecture successive de ces 64 octets dure environ 32 microsecondes (avec 150 nanosecondes par lecture d'octet). Cette durée est à rapprocher de celle d'un cycle d'écriture (comportant classiquement un effacement préalable et l'écriture proprement dite) qui vaut environ 2 millisecondes. Le coût en durée du procédé de l'invention est donc négligeable quand il est mis en oeuvre au moment d'une écriture.

## Revendications

1. Procédé d'écriture de données dans une mémoire électriquement programmable, caractérisé en ce que, pour l'écriture d'un mot dans un groupe de cellules de mémoire, sélectionné dans une ligne de la mémoire, on effectue la séquence d'opérations suivante:
- on lit l'état de cellules de mémoire de la ligne, en utilisant des valeurs de référence de lecture différentes (Vref, VRH, VRB);
- on vérifie la concordance des lectures effectuées sur une même cellule avec des valeurs de référence différentes, et si on trouve une absence de concordance pour au moins une cellule d'un mot lu, on réécrit la cellule du mot lu de cette ligne; et
- on écrit le mot désiré dans le groupe de cellules sélectionné.

2. Procédé d'écriture selon la revendication 1, caractérisé en ce que l'opération de lecture de l'état d'une cellule de mémoire comporte une comparaison d'une tension ou d'un courant de lecture issu de la cellule avec une tension ou un courant de référence, le courant et la tension de référence ayant soit une valeur centrale (Vref), soit une valeur auxiliaire (VRH) supérieure à la valeur centrale, soit une valeur auxiliaire (VRB) inférieure à la valeur centrale.

3. Procédé d'écriture selon la revendication 2, caractérisé en ce qu'on lit un mot de la ligne de mémoire avec la valeur de référence centrale (Vref), on stocke la valeur du mot dans un registre (REG) susceptible de recevoir tous les mots de la ligne, on effectue une lecture du même mot avec chacune des deux valeurs de référence auxiliaires (VRH, VRB), on examine la concordance des résultats des trois lectures, et on fournit une information de non-concordance à un séquenceur d'écriture (SEQ), la réécriture du mot de la ligne étant effectuée seulement si ce mot est lu avec un résultat non-concordant.

4. Procédé d'écriture selon la revendication 3, caractérisé en ce que, dès que le séquenceur d'écriture (SEQ) a reçu un résultat de non-concordance, les mots suivants de la ligne sont lus seulement avec la valeur de référence centrale et sont stockés dans le registre (REG) en vue d'être réécrits dans la ligne.

5. Procédé d'écriture selon la revendication 3, caractérisé en ce que, si au bout de deux lectures on détecte une non-concordance, on évite de faire la troisième lecture.

6. Procédé d'écriture selon l'une quelconque des revendications 1 à 5, caractérisé en ce que on évite de faire les trois lectures pour le mot à écrire.

7. Mémoire électriquement programmable, caractérisée en ce qu'elle comporte des moyens (SEQ) pour effectuer successivement trois lectures des cellules de mémoire d'une ligne (GC), avant chaque écriture d'un mot dans cette ligne, les trois lectures étant effectuées en utilisant trois potentiels de référence différents (Vref, VRH, VRB), et des moyens pour réécrire un mot de la ligne si les trois lectures donnent des résultats non concordants pour au moins une cellule.

8. Mémoire programmable électriquement, comportant un réseau de cellules (MM) organisées en lignes de mots, caractérisé en ce qu'elle comporte :
- un circuit de lecture (CL) apte à lire les mots de la mémoire avec trois valeurs de référence différentes (Vref, VRH, VRB);
- un registre (REG) pour stocker des mots lus dans une ligne de mémoire;
- un séquenceur d'écriture (SEQ) apte à effectuer les opérations suivantes lorsqu'il reçoit un ordre d'écriture d'un mot à un emplacement déterminé d'une ligne de la mémoire : lecture de l'état de cellules de mémoire de la ligne, en utilisant les trois valeurs de référence (Vref,VRH,VRB) de lecture différentes, réécriture systématique, si nécessaire, des cellules défectueuses d'une ligne de mémoire stockées dans le registre, et écriture d'un mot désiré à un emplacement de mot de cette ligne,
- des moyens de comparaison des résultats de la lecture d'une même cellule avec les trois valeurs de référence, (Vref,VRH,VRB) ces moyens étant connectés au séquenceur pour fournir un ordre de réécriture systématique de la cellule si une non-concordance est détectée pour au moins un mot.

## Patentansprüche

1. Verfahren zum Schreiben von Daten in einen elektrisch programmierbaren Speicher, dadurch gekennzeichnet, daß zum Schreiben eines Wortes in eine Gruppe von Speicherzellen, die in einer Speicherzeile ausgewählt wurde, die folgende Folge von Schritten durchgeführt wird:
- man fragt den Zustand von Speicherzellen der Zeile ab, indem man unterschiedliche Lesereferenzwerte (Vref, VRH, VRB) verwendet;
- man überprüft die Übereinstimmung der an ein und derselben Zelle vorgenommenen Lesevorgänge mit unterschiedlichen Referenzwerten, und wenn man keine Übereinstimmung für zumindest eine Zelle eines gelesenen Wortes findet, beschreibt man die Zelle mit dem gelesenen Wort dieser Zeile; und
- man schreibt das gewünschte Wort in die ausgewählte Zellengruppe.

2. Schreibverfahren nach Anspruch 1, dadurch gekennzeichnet, daß das Lesen des Zustands einer Speicherzelle einen Vergleich einer Lesespannung oder eines Lesestroms umfaßt, der von der Zelle kommt, mit einer Referenzspannung oder einem Referenzstrom, wobei der Referenzstrom und die Referenzspannung entweder einen Hauptwert (Vref) oder einen Hilfswert (VRH), der über dem Hauptwert liegt, oder einen Hilfswert haben, der unter dem Hauptwert liegt.

3. Schreibverfahren nach Anspruch 2, dadurch gekennzeichnet, daß man ein Wort der Speicherzeile mit dem Hauptreferenzwert (Vref) abfragt, den Wert des Wortes in einem Register (REG) speichert, das geeignet ist, alle Worte der Zeile aufzunehmen, man das gleiche Wort mit jedem der beiden Hilfswerte (VRH, VRB) abfragt, die Übereinstimmung der Resultate der drei Abfragen prüft und eine Nicht-Übereinstimmungs-Information an einen Schreibsortierer (SEQ) liefert, wobei das Neuschreiben des Wortes der Zeile nur erfolgt, wenn dieses Wort mit einem nichtübereinstimmenden Ergebnis gelesen wird.

4. Schreibverfahren nach Anspruch 3, dadurch gekennzeichnet, daß, sobald der Schreibsortierer (SEQ) ein Nicht-Übereinstimmungs-Resultat erhalten hat, die folgenden Worte der Zeile nur mit dem Hauptreferenzwert gelesen und in dem Register (REG) gespeichert werden, um in der Zeile neu beschrieben zu werden.

5. Schreibverfahren nach Anspruch 3, dadurch gekennzeichnet, daß, wenn man nach zwei Lesevorgängen eine Nicht-Übereinstimmung feststellt, man auf den dritten Lesevorgang verzichtet.

6. Schreibverfahren nach einem der Ansprüche 1 bis 5, dadurch gekennzeichnet, daß man für das zu schreibende Wort vermeidet, alle drei Lesevorgänge vorzunehmen.

7. Elektrisch programmierbarer Speicher, dadurch gekennzeichnet, daß er Vorrichtungen (SEQ) zur Durchführung von drei aufeinanderfolgenden Vorgängen zum Lesen der Speicherzellen einer Zeile (GC) vor jedem Schreiben eines Wortes in diese Zeile umfaßt, wobei die drei Lesevorgänge unter Verwendung von drei unterschiedlichen Referenzpotentialen (Vref, VRH, VRB) vorgenommen werden, sowie Vorrichtungen zum Neuschreiben eines Wortes der Zeile, wenn die drei Lesevorgänge bei mindestens einer Zelle nichtübereinstimmende Resultate ergeben.

8. Elektrisch programmierbarer Speicher, der ein Raster mit Zellen (MM) in Form von Wortzeilen umfaßt, dadurch gekennzeichnet, daß er umfaßt:
- einen Leseschaltkreis (CL), der geeignet ist, die Worte des Speichers mit drei unterschiedlichen Referenzwerten (Vref, VRH, VRB) zu lesen;
- ein Register (REG) zum Speichern von in einer Speicherzeile gelesenen Worten;
- einen Schreibsortierer (SEQ), der geeignet ist, folgende Schritte durchzuführen, wenn er einen Schreibbefehl für ein Wort an einer bestimmten Stelle einer Zeile des Speichers empfängt: Abfragen des Zustands von Speicherzellen der Zeile unter Verwendung der drei verschiedenen Lesereferenzwerte (Vref, VRH, VRB), bei Bedarf systematisches Neubeschreiben der in dem Register gespeicherten fehlerhaften Zellen einer Speicherzeile und Schreiben eines gewünschten Wortes an einer Wortstelle dieser Zeile,
- Vorrichtungen zum Vergleich der Resultate des Lesens von ein und derselben Zelle mit den drei Referenzwerten (Vref, VRH, VRB), wobei diese Vorrichtungen mit dem Sortierer verbunden sind, um den Befehl für ein systematisches Neuschreiben der Zelle zu geben, wenn eine Nicht-Übereinstimmung für mindestens ein Wort festgestellt wird.

## Claims

1. A method for writing data into an electrically programmable memory,
**characterised in that** to write a word into a group of memory cells, selected in a line of the memory, the following sequence of operations is performed:
- the memory cell state of the line is read, using different reading reference values (Vref, VRH, VRB);
- the coincidence of the readings performed on a same cell with different reference values is checked, and if an absence of coincidence is found for at least one cell of a word read, the cell of the word read from this line is rewritten; and
- the desired word is written into the selected cell group.

2. A writing method according to Claim 1,
**characterised in that** the operation for reading the state of a memory cell includes a comparison of a voltage or of a reading current emanating from the cell with a reference voltage or current, the reference current and voltage having either a central value (Vref), or an auxiliary value (VRH) greater than the central value, or an auxiliary value (VRB) less than the central value.

3. A writing method according to Claim 2,
**characterised in that** a word of the memory line is read with the central reference value (Vref), the value of the word is stored in a register (REG) capable of receiving all the words of the line, a reading of the same word is performed with each of the two auxiliary reference values (VRH, VRB), the coincidence of the results of the three readings is examined, and information regarding non-coincidence is provided to a writing sequencer (SEQ), the rewriting of the word of the line being performed only if this word is read with a non-coincident result.

4. A writing method according to Claim 3,
**characterised in that**, as soon as the writing sequencer (SEQ) has received a result of non-coincidence, the following words of the line are read only with the central reference value and are stored in the register (REG) with a view to being rewritten in the line.

5. A writing method according to Claim 3,
**characterised in that** if, at the end of two readings, non-coincidence is detected, making the third reading is avoided.

6. A writing method according to any one of Claims 1 to 5,
**characterised in that** making the three readings for the word to be written is avoided.

7. An electrically programmable memory,
**characterised in that** its comprises means (SEQ) for successively performing three readings of the memory cells of a line (GC), before each writing of a word in this line, the three readings being performed by using three different reference potentials (Vref, VRH, VRB), and means for rewriting a word of the line if the three readings give non-coincident results for at least one cell.

8. An electrically programmable memory, comprising a network of cells (MM) organised in lines of words,
**characterised in that** it comprises:
- a reading circuit (CL) capable of reading the words of the memory with three different reference values (Vref, VRH, VRB);
- a register (REG) for storing words read in one memory line;
- a writing sequencer (SEQ) capable of performing the following operations when it receives an order for writing a word at a determined location of a line of the memory, using the three different reading reference values (Vref, VRH, VRB), systematic rewriting, if necessary, of the defective cells of a memory line stored in the register, and writing a desired word at a word location of this line,
- means for comparing results of the reading of a same cell with the three reference values (Vref, VRH, VRB), these means being connected to the sequencer to supply an order for systematically rewriting the cell if non-coincidence is detected for at least one word.
